(19) Europäisches Patentamt

European Patent Office

Office européen des brevets

(11) **EP 1 456 859 B1**

(12) **EUROPÄISCHE PATENTSCHRIFT**

(45) Veröffentlichungstag und Bekanntmachung des Hinweises auf die Patenterteilung:
**15.03.2006 Patentblatt 2006/11**

(51) Int Cl.:
*H01F 17/00* (2006.01)  *H01F 21/12* (2006.01)
*H01L 23/64* (2006.01)  *H01L 27/08* (2006.01)

(21) Anmeldenummer: 02799023.3

(22) Anmeldetag: **05.12.2002**

(86) Internationale Anmeldenummer:
**PCT/DE2002/004463**

(87) Internationale Veröffentlichungsnummer:
**WO 2003/052780 (26.06.2003 Gazette 2003/26)**

(54) **INDUKTIVES BAUTEIL**

INDUCTIVE COMPONENT

COMPOSANT INDUCTIF

(84) Benannte Vertragsstaaten:
**DE FR GB IT**

(30) Priorität: **18.12.2001 DE 10162263**

(43) Veröffentlichungstag der Anmeldung:
**15.09.2004 Patentblatt 2004/38**

(73) Patentinhaber: **Infineon Technologies AG**
**81669 München (DE)**

(72) Erfinder: **TIEBOUT, Marc**
**81739 München (DE)**

(74) Vertreter: **Viering, Jentschura & Partner**
**Steinsdorfstrasse 6**
**80538 München (DE)**

(56) Entgegenhaltungen:
**EP-A- 0 654 802     DE-A- 3 941 323**
**US-A- 4 816 784     US-A- 5 021 758**
**US-A- 5 892 425**

**Beschreibung**

Die Erfindung betrifft ein induktives Bauteil.

In modernen Mobilfunkgeräten, beispielsweise in Mobiltelefonen, welche in der Regel batteriebetrieben sind, werden üblicherweise elektronische Schaltungen eingesetzt. Diese elektronischen Schaltungen setzen spannungsgesteuerte Oszillatoren ein und sollten neben einer maximalen Rauscharmut wegen des Batteriebetriebs einen minimalen Stromverbrauch aufweisen. Gemäß dem Stand der Technik, beispielsweise in [1] bis [3], werden spannungsgesteuerte Oszillatoren, welche auch unter der Abkürzung VCO (voltage controlled oscillator) bekannt sind, auf LC-Basis eingesetzt. Ein solcher LC-VCO ist ein spannungsgesteuerter Oszillator, welcher auf einer Induktivität L und einer Kapazität C basiert. In dem spannungsgesteuerten Oszillator ergibt sich somit eine Oszillationsfrequenz f gemäß

$$f = \frac{1}{2\pi\sqrt{LC}}.$$

Zum Einstellen der Oszillationsfrequenz f in dem LC-VCO wird traditionell eine spannungsgesteuerte Kapazität, ein sogenannter Varaktor, verwendet (vgl. [4]). Um größere Frequenzbereichsabgleiche vornehmen zu können, wird gegenwärtig entweder die Kapazität C (vgl. [5]) oder die Induktivität L (vgl. [6]) geschaltet.

Um den Stromverbrauch sowie das Phasenrauschen des spannungsgesteuerten Oszillators zu reduzieren, sollte dazu gemäß [3] vorzugsweise das Verhältnis L/C erhöht werden. Außerdem sollte zusätzlich jeglicher von der Induktivität erzeugte Serienwiderstand reduziert werden, da sonst ein unnötiger Leistungsverbrauch die Energiereserven in dem batteriebetriebenen Mobilfunkgerät unerwünscht reduziert.

Dies hätte den Nachteil, dass die Bereitschaftszeit bzw. die Betriebszeit des Mobilfunkgerätes erheblich reduziert werden würde.

Bei einem herkömmlichen spannungsgesteuerten Oszillator mit geschalteter Induktivität ergibt sich als Nachteil, dass die Leistung des spannungsgesteuerten Oszillators von dem Schaltelement erheblich beeinträchtigt wird. Schaltelemente mit einem niedrigen Serienwiderstand sind üblicherweise sehr groß und belasten den spannungsgesteuerten Oszillator mit fixen zusätzlichen Kapazitäten, welche nicht unerheblich sind. Kleine Schaltelemente hingegen weisen zwar nur eine niedrige zusätzliche Kapazität auf, jedoch verursachen die kleinen Schaltelemente einen erheblichen unerwünschten Serienwiderstand.

Bei einem alternativ verwendbaren spannungsgesteuerten Oszillator mit geschalteter Kapazität ergibt sich hingegen als Nachteil, dass für den spannungsgesteuerten Oszillator das Verhältnis L/C reduziert statt erhöht wird. Somit nehmen der Stromverbrauch sowie das Phasenrauschen des spannungsgesteuerten Oszillators zu, was nicht erwünscht ist. Ein weiterer Nachteil ist, dass auf Grund der geschalteten Kapazität ein erheblicher zusätzlicher Serienwiderstand mit der oben erwähnten Auswirkung entsteht.

Für ein Mobilfunkgerät, welches in einem Frequenzband von ≥ 30% einstellbar sein soll, somit dualbandfähig oder multibandfähig ist und beispielsweise sowohl den GSM-Standard (GSM = global system for mobile communication) mit 900 MHz als auch den DCS-1800-Standard (DCS = digital communication system) mit 1,8 GHz erfüllen kann, wird in dem integrierten Schaltkreis überdies ein spannungsgesteuerter Oszillator benötigt, welcher mit mindestens zwei unterschiedlichen Oszillationsfrequenzen betrieben werden kann. Dazu werden auf dem Substrat, auf dem der integrierte Schaltkreis integriert ist, üblicherweise mehrere einzelne Induktivitäten in Form von örtlich voneinander getrennten Spulen vorgesehen., welche je nach Bedarf in Reihe zu- oder abgeschaltet werden können. Diese Mehrzahl an Spulen sowie deren Verbindungsleitungen haben den Nachteil, dass sie einen erheblichen Platzverbrauch auf dem Substrat verursachen und somit eine weitere. Flächenminimierung sowie Kostenreduzierung des Mobilfunkgeräts behindert wird. Zusätzlich erhöhen die benötigten Verbindungsleitungen sowie die Mehrzahl an Spulen im Vergleich zu einer einzigen Spule den Serienwiderstand mit der oben bereits beschriebenen Folge.

Aus [7] sind Hochfrequenz-Kleinleistungs-CMOS-Oszillatoren mit elektrisch abstimmbaren offenen Schwingkreisen bekannt. Darin stellen elektrisch abstimmbare Induktivitäten einen hocheffizienten Oszillatorbetrieb sicher, welche nach dem Herstellen eingeatellt werden können, um für hochpräzise Oszillatorschaltkreise hohe Ausbeute sicherzustellen.

Ein Element mit variabler Induktivität ist aus [8] bekannt, welches einen Induktorleiter mit einer vorgegebenen Form, Schalter zum Kurzschließen von Teilen des Induktorleiters sowie Eingangs-/Ausgangsanschlüsse an den entsprechenden Enden des Induktorleiters aufweist.

Ein Halbleiterelement mit einer integrierten Induktivität wird in [9] beschrieben, bei dem die Induktivität durch erste Bereiche in einem Substrat gebildet wird, bei dem die ersten Bereiche eine längliche Form haben und entlang einer in einer Hauptoberfläche liegenden Linie voneinander in Richtung dieser Linie beabstandet sowie in wenigstens zwei Ebenen übereinander angeordnet sind. Insbesondere sind in [9] Transistoren zur Bildung einer variablen Induktivität wenigstens mit einem der ersten Bereiche verbunden.

Aus [10] ist eine Schaltkreisanordnung mit einem geschalteten Induktor bekannt, welcher einen spiralförmigen Induktor und einen parallel dazu gekoppelten MESFET zum Ein- und Ausschalten des spiralförmigen Induktors in bzw. aus einem Schaltkreis aufweist.

[11] offenbart einen monolithischen Transformator, welcher zwei in einer Ebene angeordnete Windungen aufweist, wobei Leiterbahnen der Windungen miteinander verschachtelt sind und einander kreuzen, wodurch jede Windung bezüglich eines Mittelpunktes der Windung symmetrisch ist.

Ein verschachtelter, spiralförmiger, mittig angeschlossener Induktor ist aus [12] bekannt, welcher in einer Ebene angeordnet und ineinander geschachtelt eine erste und eine zweite spiralförmige Induktorspur mit einem Mitten-Anschluss aufweist.

Der Erfindung liegt somit das Problem zugrunde, ein induktives. Bauteil anzugeben, bei dem die Induktivität der verwendeten Spule einfach variiert werden kann, ohne dass dabei zusätzliche Kapazitäten in die integrierte Schaltung des induktiven Bauteils eingekoppelt werden, ohne dass der Serienwiderstand und der Platzverbrauch auf dem Substrat erheblich erhöht werden.

Das Problem wird durch ein induktives Bauteil mit den Merkmalen gemäß dem unabhängigen Patentanspruch gelöst.

Ein induktives Bauteil weist auf genau eine Spule mit einer Gesamtinduktivität, zwei Abgreifkontakte an der Spule, und eine Steuerschaltung, wobei mittels der Steuerschaltung die effektiv wirksame Induktivität der Spule verändert werden kann.

Die Spule des induktiven Bauteils kann somit anschaulich als ein Bauteil mit variabel steuerbarer Induktivität angesehen werden. Dabei wird jedoch nicht die Gesamtinduktivität der Spule verändert, sondern lediglich der effektiv wirksame Bereich der Spule, welcher die abgegriffene effektiv wirksame Induktivität bestimmt. Das induktive Bauteil kann beispielsweise in einem VCO oder in einem Verstärker mit induktiv gesteuerter Last eingesetzt werden.

Ein Vorteil der Erfindung ist somit darin zu sehen, dass das induktive Bauteil lediglich eine einzige Spule benötigt, welche in geeigneter Weise in den Schaltkreis des induktiven Bauteils variabel einkoppelbar ist. Folglich ist das induktive Bauteil von sich aus multibandfähig, ohne dass zusätzliche Spulen zu- oder abgeschaltet werden müssen. Dieshat überdies den Vorteil, dass kaum zusätzliche Verbindungsleitungen in dem Schaltkreis des induktiven Bauteils vorgesehen sein müssen, wodurch der Serienwiderstand kaum erhöht wird.

In einer bevorzugten Ausführungsform des induktiven Bauteils ist die Spule im Wesentlichen in einer Ebene angeordnet. Dies hat den Vorteil, dass die Spule in Planartechnik hergestellt werden kann. Vorzugsweise ist das induktive Bauteil in eine integrierte Schaltung integriert. Somit kann das induktive Bauteil und folglich auch die Spule mittels üblicher Herstellungsverfahren der Halbleitertechnik auf einem Substrat erzeugt werden.

Die Spule des induktiven Bauteils weist bevorzugt mehrere Windungen sowie zwei Endkontakte auf. Vorzugsweise weist die Spule noch einen mit einem Anschluss elektrisch gekoppelten Zwischenkontakt auf. Die Spule stellt dann anschaulich eine differentielle Spule dar. Der Anschluss kann zur Spannungsversorgung oder zur Stromversorgung genutzt werden, auf Masse gelegt sein oder ungenutzt bleiben. Die zwei Endkontakte der Spule sind üblicherweise mit einem Wechselspannungsanschluss elektrisch gekoppelt. Darüber hinaus ist die differentielle Spule bevorzugt eine volldifferentielle Spule, bei welcher der Zwischenkontakt an der Mitte der Spule vorgesehen ist und somit einen Mittenkontakt darstellt.

Die Windungen der differentiellen Spule bzw. der volldifferentiellen Spule sind miteinander im Wesentlichen verschränkt angeordnet, wodurch Teilwindungen gebildet sind. Die Windungen sind dabei im Wesentlichen in der gleichen Ebene angeordnet, welche nachfolgend als Windungsebene bezeichnet wird. Anschaulich betrachtet kreuzen sich am Verschränkungspunkt jeweils zwei benachbarte Windungen folgendermaßen: Eine der beiden Windungen wechselt innerhalb der Windungsebene von einem in einem ersten Abstand zum Zentrum der Spule verlaufenden Umlauf in einen in einem zweiten Abstand zum Zentrum der Spule verlaufenden Umlauf. Die andere der beiden Windungen wechselt kurz vor dem Verschränkungspunkt aus der Windungsebene in eine parallel verlaufende Verschränkungsebene, wechselt dort unterhalb bzw. oberhalb des Verschränkungspunktes von dem in dem zweiten Abstand zum Zentrum der Spule verlaufenden Umlauf in den in dem zweiten Abstand zum Zentrum der Spule verlaufenden Umlauf und wechselt kurz nach dem Verschränkungspunkt aus der. Verschränkungsebene wieder in die Windungsebene.

In einer bevorzugten Weiterbildung des induktiven Bauteils sind die beiden innenliegenden Teilwindungen der volldifferentiellen Spule mit den zwei Endkontakten der Spule elektrisch gekoppelt. Anschaulich betrachtet sind somit die sogenannten "heißen Enden" der volldifferentiellen Spule im Spuleninneren, also mit kürzestem Abstand zum Zentrum der volldifferentiellen Spule, angeordnet.

Vorzugsweise weist die Steuerschaltung des induktiven Bauteils ein Schalterelement auf, mittels dem die Anzahl der Windungen zwischen den zwei Abgreifkontakten der Spule verändert werden kann. Dadurch ist die effektive Induktivität zwischen den zwei Abgreifkontakten stufenweise veränderbar.

Mittels des Schalterelements kann die Spule bevorzugt derart verkürzt werden, dass mindestens eine außenliegende Windung der Spule abschaltbar ist. Sind mehrere Schalterelemente in der Steuerschaltung vorgesehen, welche über mehr als zwei Abgreifkontakte mit dem induktiven Bauteil elektrisch gekoppelt sind, kann die effektive Induktivität in einer Vielzahl von Stufen verändert werden. Mittels eines einzelnen Schalterelements wird somit ein dualbandfähiges induktives Bauteil erzeugt, während mehrere Schalterelemente ein multibandfähiges induktives Bauteil zur Folge haben.

Alternativ kann die Steuerschaltung auch ein Steuerelement aufweisen, mittels dem die effektive Induktivität zwischen den zwei Abgreifkontakten der Spule in einem Steuerbereich kontinuierlich verändert werden kann. Somit wird die stufenweise Veränderbarkeit der effektiven-Induktivität noch um die Möglichkeit einer Feinjustage der effektiven Induktivität und damit des induktiven Bauteils erweitert.

In einer bevorzugten Ausführungsform des induktiven Bauteils ist in der Steuerschaltung mindestens ein Feldeffekttransistor vorgesehen. Als Feldeffekttransistor (FET) kann ein MIS-FET (Metall-Isolator-Halbleiter-FET) oder ein MOS-FET (Metall-Oxid-Halbleiter-FET), d.h. ein NMOS-FET (n-Kanal MOS-FET) oder ein PMOS-FET (p-Kanal MOS-FET), zur Anwendung kommen. Alternativ zu dem Feldeffekttransistor kann in der Steuerschaltung auch mindestens ein Bipolar-Transistor oder ein HBT (Heterobipolar-Transistor) vorgesehen sein.

Vorzugsweise ist die Spule des induktiven Bauteils auf einem Substrat integriert und weist mehrere Windungen auf, welche in Form von Leiterbahnen mit sich verändernder Leiterbahnbreite verwirklicht sind. Beispielsweise können die Leiterbahnen eine gestaffelte Leiterbahnbreite aufweisen, welche sich zum Zentrum der Spule hin verjüngt.

Ausführungsbeispiele der Erfindung sind in den Figuren dargestellt und werden im Folgenden näher erläutert. Dabei bezeichnen gleiche Bezugszeichen gleiche Komponenten.

Es zeigen

Figur 1    eine schematische Draufsicht auf eine volldifferentielle Spule gemäß einem ersten Ausführungsbeispiel der Erfindung;

Figur 2    ein Ersatzschaltbild für die volldifferentielle Spule gemäß dem ersten Ausführungsbeispiel der Erfindung;

Figur 3    ein Ersatzschaltbild für eine volldifferentielle Spule gemäß einem zweiten Ausführungsbeispiel der Erfindung;

Figur 4    ein Ersatzschaltbild für eine volldifferentielle Spule gemäß einem dritten Ausführungsbeispiel der Erfindung;

Figur 5    ein Ersatzschaltbild für eine volldifferentielle Spule gemäß einem vierten Ausführungsbeispiel der Erfindung in einem VCO;

Figur 6    ein Diagramm der Oszillationsfrequenz in dem VCO mit der volldifferentiellen Spule gemäß dem vierten Ausführungsbeispiel der Erfindung;

Figur 7    ein weiteres Diagramm der Oszillationsfrequenz in dem VCO mit der volldifferentiellen Spule gemäß dem vierten Ausführungsbeispiel der Erfindung;

Figur 8    eine schematische Draufsicht auf eine differentielle Spule gemäß einem fünften Ausführungsbeispiel der Erfindung; und

Figur 9    ein Ersatzschaltbild für die differentielle Spule gemäß dem fünften Ausführungsbeispiel der Erfindung.

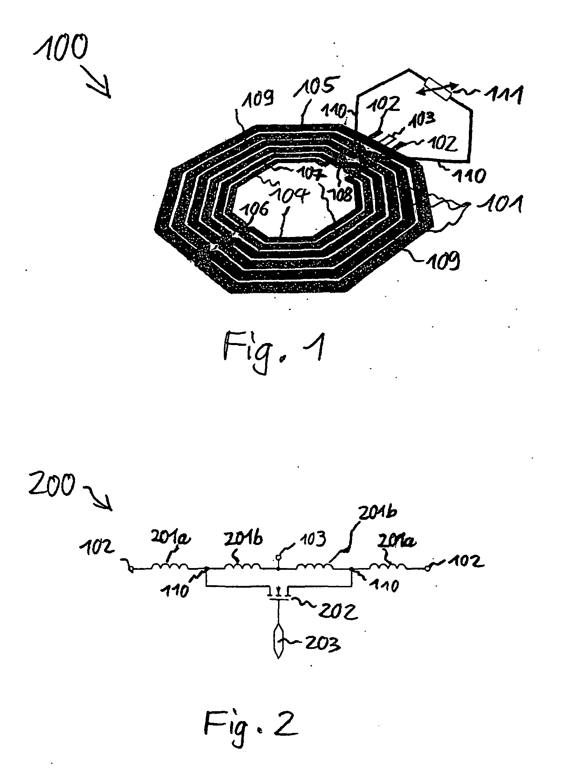

**Fig.1** zeigt eine schematische Draufsicht auf eine volldifferentielle Spule 100 gemäß einem ersten Ausführungsbeispiel der Erfindung.

Die volldifferentielle Spule 100 gemäß dem ersten Ausführungsbeispiel der Erfindung weist eine spiralförmige Anordnung von Windungen 101 auf, welche im Wesentlichen in einer Ebene liegen. Als Windungen 101 werden gemäß dem ersten Ausführungsbeispiel metallische Leiterbahnen in einer Metallisierungsebene auf einem Halbleitersubstrat angeordnet, um die volldifferentielle Spule 100 in einen integrierten Schaltkreis integrieren zu können. Somit stellt die für die Windungen 101 verwendete Metallisierungsebene die Windungsebene dar. Des Weiteren weist die volldifferentielle Spule 100 zwei Endanschlüsse 102 und einen Mittenanschluss 103 auf. Zwischen den beiden Endanschlüssen 102 kann die Gesamtinduktivität der volldifferentiellen Spule 100 abgegriffen werden, während zwischen einem Endanschluss 102 und dem Mittenanschluss 103 die halbe Gesamtinduktivität der volldifferentiellen Spule 100 abgegriffen werden kann.

Die volldifferentielle Spule 100 ist symmetrisch angeordnet, so dass sich die Windungen 101 regelmäßig überkreuzen. Anschaulich sind die Windungen 101 verschränkt miteinander angeordnet. Die beiden Endanschlüsse 102 sind mit den beiden innersten Teilwindungen 104 elektrisch gekoppelt. Der Mittenanschluss 103 ist mit der äußersten Windung 105 elektrisch gekoppelt.

Die beiden innersten Teilwindungen 104 laufen zunächst von den beiden Endanschlüssen 102 weg und sind an einem ersten Verschränkungspunkt 106 miteinander verschränkt angeordnet, so dass aus den beiden innersten Teilwindungen 104 die beiden zweitinnersten Teilwindungen 107 werden. Dazu bleibt eine der beiden innersten Teilwindungen 104 in der Windungsebene und wechselt dort vom innersten Ring in den zweitinnersten Ring. Die andere innerste Teilwindung 104 wechselt kurz vor dem Verschränkungspunkt 106 in eine zweite Metallisierungsebene, welche parallel zur Windungsebene angeordnet ist. Im Verschränkungspunkt 106 verläuft dann die innerste Teilwindung 104 in der zweiten Metallisierungsebene oberhalb bzw. unterhalb der innersten Teilwindung 104 in der Windungsebene. Kurz nach dem Verschränkungspunkt 106 wechselt die innerste Teilwindung 104 aus der zweiten Metallisierungsebene zurück in die Windungsebene und wird dort als zweitinnerste Teilwindung 107 weitergeführt. Dabei sind im Bereich des Verschränkungspunktes 106 die Windungen 101 derart angeordnet, dass kein elektrischer Kontakt zwischen den Windungen 101 zustande kommt.

Nachdem aus den innersten Teilwindungen 104 die zweitinnersten Teilwindungen 107 geworden sind, laufen diese in Richtung Endanschlüsse 102 zurück, wo sie einen weiteren Verschränkungspunkt 108 erreichen. An dem weiteren Verschränkungspunkt 108 sind die zweitinnersten Teilwindungen 107 wiederum miteinander verschränkt. Die Verschränkung der Windungen 101 am weiteren Verschränkungspunkt 108 erfolgt in gleicher Weise wie am Verschränkungspunkt 106. Das Hin und Her der Windungen 101 zwischen dem Verschränkungspunkt 106 und dem weiteren Verschränkungspunkt 108 erfolgt bis hin zu der äußersten Windung 105. Diese macht einen vollständigen Umlauf um die spiralförmig aufgerollten bisherigen Windungen 101. In Höhe des weiteren Verschränkungspunktes 108 ist die äußerste Windung 105 mit dem Mittenanschluss 103 der volldifferentiellen Spule 100 elektrisch gekoppelt.

Gemäß dem ersten Ausführungsbeispiel nimmt die Leiterbahnbreite der Windungen 101, wie in der Veröffentlichung [3] beschrieben, von den innersten Teilwindungen 104 bis zu der äußersten Windung 105 immer mehr zu. Dadurch kann das Verhältnis L/C und L/R für die volldifferentielle Spule 100 optimiert werden.

Die beiden zweitäußersten Teilwindungen 109 sind in Höhe des weiteren Verschränkungspunktes 108 nicht nur mit den weiter innen liegenden Windungen 101 elektrisch gekoppelt, sondern weisen noch zwei Abgreifkontakte 110 auf. An diese beiden Abgreifkontakte 110 ist ein Steuerelement 111 elektrisch gekoppelt, welches als variabler Widerstand symbolisiert ist.

Mittels des Steuerelements 111 kann die Anzahl der wirksamen Windungen 101 der volldifferentiellen Spule 100 verändert werden. Wenn das Steuerelement 111 die beiden Abgreifkontakte 110 kurzschließt, wird die volldifferentielle Spule 100 um die beiden zweitäußersten Teilwindungen 109 sowie die äußerste Windung 105 verkürzt. Wenn das Steuerelement 111 die beiden Abgreifkontakte 110 voneinander elektrisch trennt, wirkt die volldifferentielle Spule 100 mit ihrer vollen Windungszahl. Die volldifferentielle Spule 100 stellt mittels des Steuerelements 111 somit anschaulich eine umschaltbare Spule dar. Das Steuerelement 111 kann jedoch auch jeden Zwischenzustand zwischen dem Zustand "Abgreifkontakte 110 kurzgeschlossen" und dem Zustand "Abgreifkontakte 110 getrennt voneinander" einstellen. Somit sind auch beliebige Zwischenwerte für die effektiv wirksame Induktivität einstellbar, wodurch eine variable Induktivität entsteht. Bei obiger Beschreibung gilt stets, dass die effektiv wirksame Induktivität proportional zum Quadrat der wirksamen Windungszahl ist.

Das sogenannte "heiße Ende" der volldifferentiellen Spule 100 befindet sich in der dargestellten Geometrie im Inneren der volldifferentiellen Spule 100, also an den beiden innersten Teilwindungen 104. Der Mittenanschluss 103 der volldifferentiellen Spule 100 kann bei differentiellen VCO-Schaltungen auf die Masse der Wechselspannung im VCO gelegt werden oder zur Spannungsversorgung bzw. Stromversorgung genutzt werden. Da das Hochfrequenzsignal zwischen den beiden Endanschlüssen 102 und dem Mittenanschluss 103 anliegt, verteilt sich der Spannungshub geometrisch über die volldifferentielle Spule 100 von Null beim Mittenanschluss 103 bis zum Maximum bei den beiden Endanschlüssen 102. Zusätzliche Kapazitäten im Bereich des Mittenanschlusses 103 haben somit keinen Einfluss auf den VCO. Wird nun mittels der beiden Abgreifkontakte 110 sowie des Steuerelements 111 eine aktive Verkürzung der volldifferentiellen Spule 100 vorgenommen, werden aus der Mitte der volldifferentiellen Spule 100 einige Windungen 101 ausgeblendet. Die dadurch entstehenden zusätzlichen Kapazitäten haben kaum Einfluss auf den VCO, da die aktive Verkürzung im Bereich des Mittenanschlusses 103 vorgenommen wird. Da zusätzliche Kapazitäten am Mittenanschluss 103 kaum stören, kann ein großes Steuerelement 111 mit einem geringen Serienwiderstand verwendet werden. Somit kann der Serienwiderstand der volldifferentiellen Spule 100 auf Grund eines geeigneten Designs der volldifferentiellen Spule 100 sowie des VCO reduziert werden.

In **Fig.2** ist ein Ersatzschaltbild 200 für die volldifferentielle Spule 100 gemäß Fig.1 dargestellt.

In dem Ersatzschaltbild 200 ist die volldifferentielle Spule 100 in schematischer Weise dargestellt. Zwischen den beiden Endanschlüssen 102 sind die Windungen 101 der volldifferentiellen Spule 100 in Form von vier Windungsgruppen 201a, 201b angeordnet. Die Anzahl an Windungen 101 in den einzelnen Windungsgruppen 201a, 201b ist beliebig. Jedoch ist aus Symmetriegründen zur Vermeidung von parasitären Kapazitäten und von störenden Magnetfeldern die Anzahl an Windungen 101 in den beiden äußeren Windungsgruppen 201a vorzugsweise gleich groß. Ebenso ist die Anzahl an Windungen 101 in den beiden inneren Windungsgruppen 201b bevorzugt gleich groß.

Des Weiteren sind in dem Ersatzschaltbild 200 der Mittenanschluss 103 sowie die beiden Abgreifkontakte 110 der volldifferentiellen Spule 100 dargestellt.

In dem ersten Ausführungsbeispiel der Erfindung ist das Steuerelement 111 in der Form eines NMOS-FETs 202 (n-Kanal-Feldeffekttransistor) verwirklicht. Dabei sind die beiden Abgreifkontakte 110 der volldifferentiellen Spule 100 mit dem Source-Kontakt und dem Drain-Kontakt des NMOS-FETs 202 elektrisch verbunden.

Wenn an den Gate-Kontakt des NMOS-FETs 202 eine Steuerspannung 203 angelegt wird, bildet sich im Kanalbereich des NMOS-FETs 202 ein elektrisch leitender Ladungsträgerkanal aus und der NMOS-FET 202 schaltet-durch. Somit werden die beiden Abgreifkontakte 110 kurzgeschlossen und die beiden inneren Windungsgruppen 201b der volldifferentiellen Spule 100 überbrückt. Die effektiv wirksame Induktivität der volldifferentiellen Spule 100 wird nun ausschließlich von den beiden äußeren Windungsgruppen 201a bestimmt. Das Anlegen der Steuerspannung 203 führt somit zu einer Änderung der Oszillationsfrequenz im VCO.

Wenn an dem Gate-Kontakt des NMOS-FETs 202 keine Steuerspannung 203 anliegt, sperrt der NMOS-FET 202. Folglich wird keine elektrische Verbindung zwischen den beiden Abgreifkontakten 110 hergestellt. Die inneren Windungsgruppen 201b sind somit elektrisch aktiv und die volldifferentielle Spule 100 wirkt mit ihrer Gesamtinduktivität.

Des Weiteren kann die effektiv wirksame Induktivität der volldifferentiellen Spule 100 dadurch variiert werden, dass der NMOS-FET 202 bei in geeigneter Höhe anliegender Steuerspannung 203 nicht vollständig durchschaltet und somit ein Stromfluss sowohl durch die inneren Windungsgruppen 201b als auch durch den NMOS-FET 202 ermöglicht wird. Entsprechend dem Stromfluss durch die inneren Windungsgruppen 201b kann nun die effektiv wirksame Induktivität der volldifferentiellen Spule 100 zwischen den beiden Grenzwerten kontinuierlich variiert werden. Der NMOS-FET 202 wirkt somit nicht nur als Schalter sondern auch als variable Steuereinheit.

Alternativ kann statt des NMOS-FET 202 auch ein PMOS-FET vorgesehen sein, welcher beim Anliegen einer Steuerspannung 203 sperrt und beim Fehlen einer Steuerspannung 203 elektrisch leitend ist.

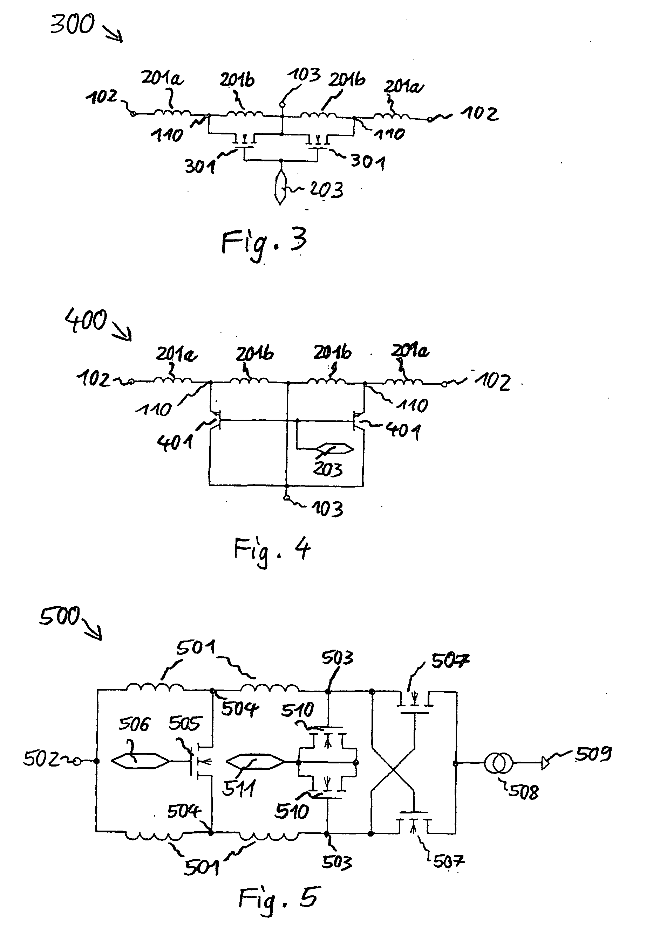

**Fig.3** zeigt ein Ersatzschaltbild 300 für eine volldifferentielle Spule 100 gemäß einem zweiten Ausführungsbeispiel der Erfindung.

Das Ersatzschaltbild 300 des zweiten Ausführungsbeispiels unterscheidet sich von dem Ersatzschaltbild 200 des ersten Ausführungsbeispiels dadurch, dass in der Steuerschaltung für die volldifferentielle Spule 100 zwei NMOS-FETs 301 vorgesehen sind.

Die zwei NMOS-FETs 301 sind derart an die volldifferentielle Spule 100 gekoppelt, dass beim Einkoppeln einer Steuerspannung 203, welche dann simultan an dem jeweiligen Gate-Kontakt der zwei NMOS-FETs 301 anliegt und die zwei NMOS-FETs 301 elektrisch leitend macht, der Mittenanschluss 103 der volldifferentiellen Spule 100 mit den zwei Abgreifkontakten 110 elektrisch gekoppelt wird. Folglich werden die beiden inneren Windungsgruppen 201b überbrückt und die an den zwei Endanschlüssen 102 der volldifferentiellen Spule 100 effektiv wirksame Induktivität wird von den beiden äußeren Windungsgruppen 201a gebildet.

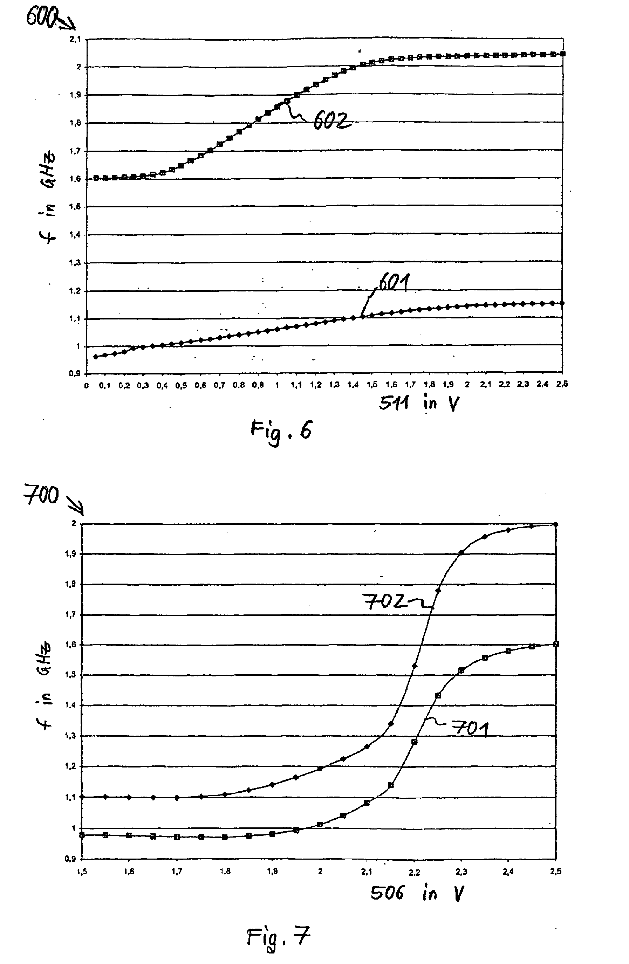

In **Fig.4** ist ein Ersatzschaltbild 400 für die volldifferentielle Spule 100 gemäß einem dritten Ausführungsbeispiel der Erfindung dargestellt.

Das Ersatzschaltbild 400 des dritten Ausführungsbeispiels unterscheidet sich von dem Ersatzschaltbild 200 des ersten Ausführungsbeispiels dadurch, dass in der Steuerschaltung für die volldifferentielle Spule 100 zwei Bipolar-Transistoren 401 vorgesehen sind.

Die zwei Bipolar-Transistoren 401 sind derart an die volldifferentielle Spule 100 gekoppelt, dass jeweils ein Abgreifkontakt 110 mit einem Emitter-Kontakt eines der zwei Bipolar-Transistoren 401 elektrisch gekoppelt ist. Die Kollektor-Kontakte der zwei Bipolar-Transistoren 401 sind mit dem Mittenanschluss der volldifferentiellen Spule 100 elektrisch gekoppelt. Je nach gewünschtem Zustand der Bipolar-Transistoren 401 kann eine Steuerspannung 203 simultan an die Basis-Kontakte der zwei Bipolar-Transistoren 401 angelegt werden.

Die im Ersatzschaltbild 400 des dritten Ausführungsbeispiels dargestellte Steuerschaltung verhält sich trotz anderer Bauelemente analog zu der im Ersatzschaltbild 300 des zweiten Ausführungsbeispiels dargestellten Steuerschaltung.

**Fig.5** zeigt ein Ersatzschaltbild 500 für eine volldifferentielle Spule 100 gemäß einem vierten Ausführungsbeispiel der Erfindung in einem VCO.

Das Ersatzschaltbild 500 gemäß dem vierten Ausführungsbeispiel stellt eine Testschaltung eines VCO mit einer volldifferentiellen Spule 100 dar, welche eine Oszillationsfrequenz zwischen 900 MHz und 1,8 GHz in dem VCO ermöglicht.

Die volldifferentielle Spule 100 wird durch vier Windungsgruppen 501 symbolisiert. Die zwei Endanschlüsse der volldifferentiellen Spule 100 sind zu einem gemeinsamen Endanschluss 502 zusammengefasst. An diesen gemeinsamen Endanschluss 502 wird gemäß diesem Ausführungsbeispiel eine konstante Spannung von +1,5 V angelegt. Der Mittenanschluss der volldifferentiellen Spule 100 ist dagegen in zwei Teilanschlüsse 503 aufgeteilt. Der Endanschluss 502 und die Teilanschlüsse 503 sind derart angeordnet, dass sich zwischen jedem Teilanschluss 503 sowie dem Endanschluss 502 zwei Windungsgruppen 501 befinden. Zwischen diesen jeweils zwei Windungsgruppen 501 ist des Weiteren noch jeweils ein Abgreifkontakt 504 angeordnet. Die beiden Abgreifkontakte 504 sind mittels eines NMOS-FETs 505 miteinander gekoppelt, welcher mittels einer Steuerspannung 506, in gleicher Weise wie gemäß dem in Fig.2 dargestellten Ausführungsbeispiel, wunschgemäß gesteuert werden kann.

Die beiden Teilanschlüsse 503 sind über jeweils einen NMOS-FET 507 und ein gemeinsames Konstantstrom-Bauelement 508 mit dem Masseanschluss 509 des Schaltkreises elektrisch gekoppelt. Die Rückkopplung durch die zwei NMOS-FETs 507 bildet einen negativen Widerstand, wodurch eine Oszillation in dem VCO erst ermöglicht wird. Das Konstantstrom-Bauelement 508 stellt trotz schwankender Spannungen einen konstanten Stromfluss in dem VCO sicher.

Die beiden Teilanschlüsse 503 sind des Weiteren noch mit dem jeweiligen Gate-Kontakt zweier als Kondensatoren wirkender NMOS-FETs 510 elektrisch gekoppelt. In Abhängigkeit davon, wie groß die am jeweiligen Source-Kontakt sowie am jeweiligen Drain-Kontakt der beiden NMOS-FETs 510 anliegende Steuerspannung 511 ist, wird die auf die beiden Teilanschlüsse 503 einwirkende Kapazität verändert. Die beiden NMOS-FETs 510 stellen somit einen sogenannten Varaktor dar. Auch diese Variation der Kapazitäten an den beiden Teilanschlüssen 503 ermöglicht eine Steuerung sowie eine Feinjustage der in dem VCO vorliegenden Oszillationsfrequenz f.

In **Fig.6** ist ein Diagramm 600 der Oszillationsfrequenz in dem VCO mit der volldifferentiellen Spule 100 gemäß Fig.5 dargestellt.

In dem Diagramm 600 ist die Oszillationsfrequenz f des VCO gemäß Fig.5 in Abhängigkeit von der Steuerspannung 511 zur Kapazitätssteuerung dargestellt. Die Kurve 601 gibt diejenigen Messwerte für die Oszillationsfrequenz f wieder, welche bei einer Steuerspannung 506 zur Induktivitätsvariation von 0 V gemessen wurden, während die Kurve 602 diejenigen Messwerte für die Oszillationsfrequenz f wiedergibt, welche bei einer Steuerspannung 506 zur Induktivitätsvariation von 2,5 V gemessen wurden.

Die beiden Kurven 601 und 602 zeigen, dass sich mittels einer Änderung der Steuerspannung 506 zur Induktivitätsvariation die Oszillationsfrequenz f zwischen einem ersten Bereich, welcher zwischen 0,95 GHz und 1,15 GHz liegt, und einem zweiten Bereich, welcher zwischen 1,6 GHz und 2,05 GHz liegt, hin- und herschalten lässt. Dabei wird die volldifferentielle Spule 100 mittels des als Schalter wirkenden NMOS-FETs 505 aktiv verkürzt. Mittels einer Variation der Steuerspannung 511 zur Kapazitätssteuerung kann eine Feinjustage der Oszillationsfrequenz f in dem VCO vorgenommen werden.

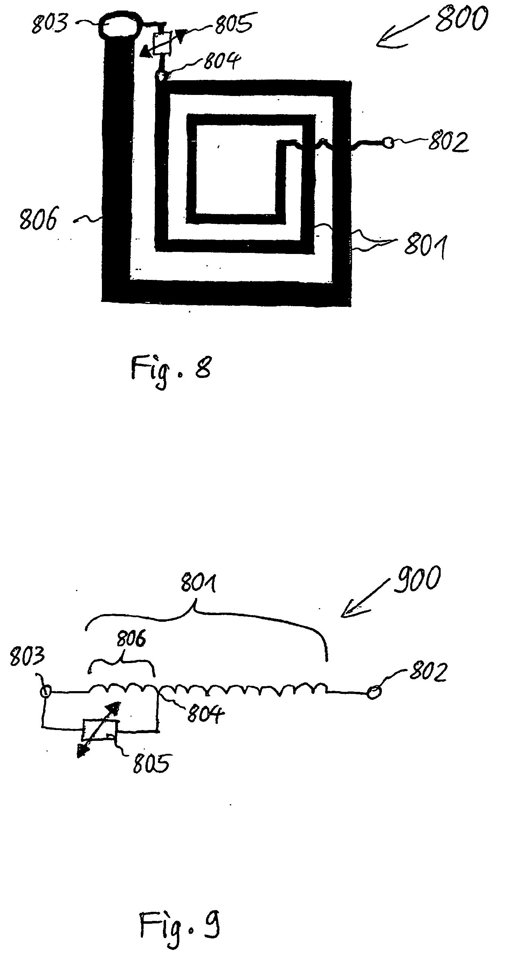

**Fig.7** zeigt ein weiteres Diagramm 700 der Oszillationsfrequenz in dem VCO mit der volldifferentiellen Spule 100 gemäß Fig.5.

In dem weiteren Diagramm 700 ist die Oszillationsfrequenz f des VCO gemäß Fig.5 in Abhängigkeit von der Steuerspannung 506 zur Induktivitätsvariation dargestellt. Die Kurve 701 gibt diejenigen Messwerte für die Oszillationsfrequenz f wieder, welche bei einer Steuerspannung 511 zur Kapazitätssteuerung von 0 V gemessen wurden, während die Kurve 702 diejenigen Messwerte für die Oszillationsfrequenz f wiedergibt, welche bei einer Steuerspannung 511 zur Kapazitätssteuerung von 2,5 V gemessen wurden.

Die beiden Kurven 701 und 702 zeigen, dass sich mittels einer Änderung der Steuerspannung 511 zur Kapazitätssteuerung die Oszillationsfrequenz f innerhalb eines ersten Bereiches, welcher zwischen 0,95 GHz und 1,6 GHz liegt, und innerhalb eines zweiten Bereiches, welcher zwischen 1,1 GHz und 2 GHz liegt, variabel einstellen lässt. Dabei wird die effektive Induktivität der volldifferentiellen Spule 100 mittels den als Kondensatoren wirkenden NMOS-FETs 510 variabel verändert. Mittels einer Variation der Steuerspannung 506 zur Induktivitätsvariation scheint eine Feinjustage der Oszillationsfrequenz f in dem VCO möglich zu sein.

In **Fig.8** ist eine schematische Draufsicht auf eine differentielle Spule 800 gemäß einem fünften Ausführungsbeispiel der Erfindung dargestellt.

Die differentielle Spule 800 gemäß dem fünften Ausführungsbeispiel weist spiralförmig angeordnete Windungen 801 auf, welche in Form von Leiterbahnen auf einer Substratoberfläche integriert sind. Gemäß dem fünften Ausführungsbeispiel erfolgt die spiralförmige Anordnung der Windungen 801 quadratisch. Alternativ kann die spiralförmige Anordnung der Windungen 801 beispielsweise auch oktogonal, rund oder rechteckig sein. Das innerste Ende der Windungen 801 ist mit einem ersten Endanschluss 802 elektrisch gekoppelt. Dabei ist der elektrische Kontakt zwischen dem innersten Ende der Windungen 801 und dem ersten Endanschluss 802 derart vorgesehen, dass dieser die äußeren Windungen 801 elektrisch isoliert überbrückt.

Das äußerste Ende der Windungen 801 ist mit einem zweiten Endanschluss 803 elektrisch gekoppelt. An der zweitäußersten Windung ist ein Abgreifkontakt 804 vorgesehen, welcher über ein Steuerelement 805 mit dem zweiten Endanschluss 803 elektrisch gekoppelt ist. Das Steuerelement 805 ist dabei als variabler Widerstand symbolisiert.

Mittels des Steuerelements 805 kann die Anzahl der wirksamen Windungen 801 der differentiellen Spule 800 verändert werden.

Wenn das Steuerelement 805 den Abgreifkontakt 804 mit dem zweiten Endanschluss 803 kurzschließt, wird die differentielle Spule 800 um die äußerste Windung, welche somit eine abschaltbare Windung 806 darstellt, verkürzt. Wenn das Steuerelement 805 den Abgreifkontakt 804 von dem zweiten Endanschluss 803 elektrisch trennt, wirkt die differentielle Spule 800 mit ihrer vollen Windungszahl. Die differentielle Spule 800 stellt mittels des Steuerelements 805 somit anschaulich eine umschaltbare Spule dar. Das Steuerelement 805 kann jedoch auch jeden Zwischenzustand zwischen dem Zustand "Abgreifkontakt 804 mit zweitem Endanschluss 803 kurzgeschlossen" und dem Zustand "Abgreifkontakt 804 getrennt von zweitem Endanschluss 803" einstellen. Somit sind auch beliebige Zwischenwerte für die effektiv wirksame Induktivität einstellbar, wodurch eine variable Induktivität entsteht. Bei obiger Beschreibung gilt stets, dass die effektiv wirksame Induktivität proportional zum Quadrat der wirksamen Windungszahl ist.

**Fig.9** zeigt ein Ersatzschaltbild 900 für die differentielle Spule 800 gemäß Fig.8.

In diesem Dokument sind folgende Veröffentlichungen zitiert:

[1] Cranickx J., Steyaert M.S.J.: "A 1.8-GHz Low-Phase-Noise CMOS VCO Using Optimized Hollow Spiral Inductors" in IEEE J. of Solid-State Circuits, Vol. 32, No. 5, pp. 736-744 (1997)

[2] Zannoth M., Kolb B., Fenk J., Weigel R.: "A Fully Integrated VCO at 2 GHz" in IEEE J. of Solid-State Circuits, Vol. 33, No. 12, pp. 1987-1991 (1998)

[3] Tiebout M.: "Low-Power Low-Phase-Noise Differentially Tuned Quadrature VCO Design in Standard CMOS" in IEEE J. of Solid-State Circuits, Vol. 36, No. 7, pp. 1018-1024 (2001)

[4] Andreani P.: "A Comparison between Two 1.8 GHz CMOS VCOs Tuned by Different Varactors" in Proc. of European Solid-State Circuits Conf., pp. 380-383 (1998)

[5] Kral A., Behbahani F., Abidi A.A.: "RF-CMOS Oscillators with Switched Tuning" in IEEE Proc. of Custom Integrated Circuits Conf., pp. 555-558 (1998)

[6] Yim S.M., Kenneth K.O.: "Demonstration of a Switched Resonator Concept in a Dual-Band Monolithic CMOS LC-Tuned VCO" in IEEE Proc. of Custom Integrated Circuits Conf., pp. 205-208 (2001)

[7] EP 0 720 185 A1

[8] EP 0 654 802 A1

[9] DE 39 41 323 A1

[10] US 5 021 758

[11] US 4 816 784

[12] US 5 892 425

**Bezugszeichenliste**

| 100 | volldifferentielle Spule gemäß erstem Ausführungsbeispiel der Erfindung |
|---|---|
| 101 | Windung |
| 102 | Endanschluss |
| 103 | Mittenanschluss |
| 104 | innerste Teilwindung |
| 105 | äußerste Windung |
| 106 | Verschränkungspunkt |
| 107 | zweitinnerste Teilwindung |
| 108 | weiterer Verschränkungspunkt |
| 109 | zweitäußerste Teilwindung |
| 110 | Abgreifkontakt |
| 111 | Steuerelement |
| 200 | Ersatzschaltbild für das erste Ausführungsbeispiel |
| 201a | äußere Windungsgruppe |
| 201b | innere Windungsgruppe |
| 202 | NMOS-FET |
| 203 | Steuerspannung |
| 300 | Ersatzschaltbild für ein zweites Ausführungsbeispiel |
| 301 | NMOS-FET |
| 400 | Ersatzschaltbild für ein drittes Ausführungsbeispiel |
| 401 | Bipolar-Transistor |
| 500 | Ersatzschaltbild für ein viertes Ausführungsbeispiel |
| 501 | Windungsgruppe |
| 502 | Endanschluss |
| 503 | Teilanschluss |
| 504 | Abgreifkontakt |
| 505 | NMOS-FET zur Induktivitätsvariation |
| 506 | Steuerspannung zur Induktivitätsvariation |
| 507 | NMOS-FET zur Rückkopplung |
| 508 | Konstantstrom-Bauelement |
| 509 | Masseanschluss |
| 510 | NMOS-FET zur Kapazitätssteuerung |
| 511 | Steuerspannung zur Kapazitätssteuerung |
| 600 | Diagramm der Oszillationsfrequenz für das vierte Ausführungsbeispiel |
| f | Oszillationsfrequenz |
| 601 | Kurve für 0 V Steuerspannung zur Induktivitätsvariation |
| 602 | Kurve für 2,5 V Steuerspannung zur Induktivitätsvariation |
| 700 | weiteres Diagramm der Oszillationsfrequenz für das vierte Ausführungsbeispiel |
| 701 | Kurve für 0 V Steuerspannung zur Kapazitätssteuerung |
| 702 | Kurve für 2,5 V Steuerspannung zur Kapazitätssteuerung |
| 800 | differentielle Spule gemäß fünftem Ausführungsbeispiel der Erfindung |
| 801 | Windungen |
| 802 | erster Endanschluss |
| 803 | zweiter Endanschluss |
| 804 | Abgreifkontakt |
| 805 | Steuerelement |
| 806 | abschaltbare Windung |
| 900 | Ersatzschaltbild für das fünfte Ausführungsbeispiel |

**Patentansprüche**

1. Induktives Bauteil

   • mit genau einer Spule (100; 800) mit einer Gesamtinduktivität,
   • mit zwei Abgreifkontakten (110; 803, 804) an der Spule, und
   • mit einer zwischen die zwei Abgreifkontakte geschalteten Steuerschaltung (111; 805),
   • wobei mittels der Steuerschaltung die effektiv wirksame Induktivität der Spule verändert werden kann, und
   • wobei die Spule mehrere spiralförmige Windungen (101; 801) aufweist, welche in Form von Leiterbahnen mit einer sich zum Zentrum der mehreren spiralförmigen Windungen hin verjüngenden Leiterbahnbreite verwirklicht sind.

2. Induktives Bauteil gemäß Anspruch 1, bei dem die Spule im Wesentlichen in einer Ebene angeordnet ist.

3. Induktives Bauteil gemäß Anspruch 1 oder 2,

**4.** Induktives Bauteil gemäß einem der Ansprüche 1 bis 3,
bei dem die Spule zwei Endkontakte atifweist.

**5.** Induktives Bauteil gemäß einem der Ansprüche 1 bis 4,
bei dem die Spule einen Zwischenkontakt aufweist, wodurch die Spule eine differentielle Spule darstellt.

**6.** Induktives Bauteil gemäß Anspruch 5,
bei dem der Zwischenkontakt mit einem Masseanschluss und die zwei Endkontakte mit einem Wechselspannungsanschluss elektrisch gekoppelt sind.

**7.** Induktives Bauteil gemäß Anspruch 5 oder 6,
bei dem die differentielle Spule eine volldifferentielle Spule ist, bei welcher der Zwischenkontakt an der Mitte der Spule vorgesehen ist und somit einen Mittenkontakt darstellt.

**8.** Induktives Bauteil gemäß einem der Ansprüche 5 bis 7,
bei dem die Windungen der differentiellen Spule miteinander im Wesentlichen verschränkt angeordnet sind, wodurch Teilwindungen gebildet sind.

**9.** Induktives Bauteil gemäß Anspruch 8,
bei dem die beiden innenliegenden Teilwindungen der volldifferentiellen Spule mit den zwei Endkontakten der Spule elektrisch gekoppelt sind.

**10.** Induktives Bauteil gemäß einem der Ansprüche 4 bis 9,
bei dem die Steuerschaltung ein Schalterelement aufweist, mittels dem die Anzahl der Windungen zwischen den zwei Abgreifkontakten der Spule verändert werden kann, wodurch die effektive Induktivität zwischen den zwei Abgreifkontakten stufenweise veränderbar ist.

**11.** Induktives Bauteil gemäß Anspruch 10,
bei dem mittels des Schalterelements die Spule derart verkürzt werden kann, dass mindestens eine außenliegende Windung der Spule abschaltbar ist.

**12.** Induktives Bauteil gemäß einem der Ansprüche 4 bis 9,
bei dem die Steuerschaltung ein Steuerelement aufweist, mittels dem die effektive Induktivität zwischen den zwei Abgreifkontakten der Spule in einem Steuerbereich kontinuierlich verändert werden kann.

**13.** Induktives Bauteil gemäß einem der Ansprüche 1 bis 12, bei dem die Steuerschaltung mindestens einen Feldeffekttransistor aufweist.

**14.** Induktives Bauteil gemäß einem der Ansprüche 1 bis 13, bei dem die Spule auf einem Substrat integriert ist.

**15.** Induktives Bauteil gemäß einem der Ansprüche 1 bis 14, bei dem die Leiterbahnen eine gestaffelte Leiterbahnbreite aufweisen.

**16.** Spannungsgesteuerter Oszillator (VCO), welcher ein induktives Bauteil gemäß einem der Ansprüche 1 bis 15 aufweist.

**17.** Verstärker mit induktiv gesteuerter Last, welcher ein induktives Bauteil gemäß einem der Ansprüche 1 bis 15 aufweist.

**Claims**

**1.** An inductive component

• having precisely one coil (100; 800) having a total inductance,
• having two tapping contacts (110; 803, 804) at the coil, and
• having a control circuit (111; 805) connected between the two tapping contacts,
• it being possible to alter the effective inductance of the coil by means of the control circuit, and
• the coil having a plurality of spiral turns (101; 801) which are realized in the form of conductor tracks having a conductor track width that tapers toward the center of the plurality of spiral turns.

**2.** The inductive component as claimed in claim 1, in which the coil is arranged essentially in one plane.

**3.** The inductive component as claimed in claim 1 or 2, which is integrated into an integrated circuit.

**4.** The inductive component as claimed in one of claims 1 to 3,
in which the coil has two end contacts.

**5.** The inductive component as claimed in one of claims 1 to 4,
in which the coil has an intermediate contact, as a result of which the coil represents a differential coil.

**6.** The inductive component as claimed in claim 5, in which the intermediate contact is electrically coupled to a ground connection and the two end contacts are electrically coupled to an AC voltage connection.

**7.** The inductive component as claimed in claim 5 or 6, in which the differential coil is a fully differential coil in which the intermediate contact is provided at the center of the coil and thus represents a center contact.

8. The inductive component as claimed in one of claims 5 to 7,
in which the turns of the differential coil are arranged such that they are essentially transposed with one another, thereby forming partial turns.

9. The inductive component as claimed in claim 8, in which the two inner partial turns of the fully differential coil are electrically coupled to the two end contacts of the coil.

10. The inductive component as claimed in one of claims 4 to 9,
in which the control circuit has a switch element by means of which it is possible to alter the number of turns between the two tapping contacts of the coil, as a result of which it is possible to alter the effective inductance between the two tapping contacts in a stepwise manner.

11. The inductive component as claimed in claim 10, in which the coil can be shortened by means of the switch element in such a way that at least one outer turn of the coil can be disconnected.

12. The inductive component as claimed in one of claims 4 to 9,
in which the control circuit has a control element by means of which it is possible to alter the effective inductance between the two tapping contacts of the coil in a continuous manner in a control range.

13. The inductive component as claimed in one of claims 1 to 12,
in which the control circuit has at least one field-effect transistor.

14. The inductive component as claimed in one of claims 1 to 13,
in which the coil is integrated on a substrate.

15. The inductive component as claimed in one of claims 1 to 14,
in which the conductor tracks have a staggered conductor track width.

16. A voltage controlled oscillator (VCO) having an inductive component as claimed in one of claims 1 to 15.

17. An amplifier with an inductively controlled load having an inductive component as claimed in one of claims 1 to 15.

**Revendications**

1. Composant inductif comportant :

   • exactement une bobine (100; 800) ayant une inductance totale,
   • deux contacts ajustables (110; 803; 804) sur la bobine et
   • un circuit de commande (111; 805) commuté entre les deux contacts ajustables,
   • dans lequel on peut modifier l'inductance efficace de la bobine au moyen du circuit de commande et
   • dans lequel la bobine présente plusieurs enroulements spiralés (101; 801) qui se présentent sous la forme de pistes conductrices ayant une largeur s'amincissant vers le centre des enroulements spiralés.

2. Composant inductif selon la revendication 1, dans lequel la bobine est agencée sensiblement dans un plan.

3. Composant inductif selon la revendication 1 ou 2, qui est incorporé à un circuit intégré.

4. Composant inductif selon l'une quelconque des revendications 1 à 3, dans lequel la bobine présente deux contacts terminaux.

5. Composant inductif selon l'une quelconque des revendications 1 à 4, dans lequel la bobine présente un contact intermédiaire, si bien que la bobine représente une bobine différentielle.

6. Composant inductif selon la revendication 5, dans lequel le contact intermédiaire est couplé électriquement à une connexion de terre et les deux contacts terminaux à une connexion de tension alternative.

7. Composant inductif selon la revendication 5 ou 6, dans lequel la bobine différentielle est une bobine entièrement différentielle, dans laquelle le contact intermédiaire est agencé au centre de la bobine et représente donc un contact central.

8. Composant inductif selon l'une quelconque des revendications 5 à 7, dans lequel les enroulements de la bobine différentielle sont agencés sensiblement entrelacés les uns avec les autres, ce qui entraîne la formation d'enroulements partiels.

9. Composant inductif selon la revendication 8, dans lequel les deux enroulements partiels internes de la bobine entièrement différentielle sont couplés électriquement aux deux contacts terminaux de la bobine.

**10.** Composant inductif selon l'une quelconque des revendications 4 à 9, dans lequel le circuit de commande présente un élément de commutation, au moyen duquel on peut modifier le nombre des enroulements entre les deux contacts ajustables de la bobine, ce qui permet de modifier progressivement l'inductance efficace entre les deux contacts ajustables.

**11.** Composant inductif selon la revendication 10, dans lequel on peut, au moyen de l'élément de commutation, raccourcir la bobine de manière qu'on puisse déconnecter au moins un enroulement externe de la bobine.

**12.** Composant inductif selon l'une quelconque des revendications 4 à 9, dans lequel le circuit de commande présente un élément de commande, au moyen duquel on peut modifier en continu l'inductance efficace entre les deux contacts ajustables de la bobine dans une plage de commande.

**13.** Composant inductif selon l'une quelconque des revendications 1 à 12, dans lequel le circuit de commande présente au moins un transistor à effet de champ.

**14.** Composant inductif selon l'une quelconque des revendications 1 à 13, dans lequel la bobine est intégrée à un substrat.

**15.** Composant inductif selon l'une quelconque des revendications 1 à 14, dans lequel les pistes conductrices présentent une largeur progressive.

**16.** Oscillateur asservi en tension (VCO), qui présente un composant inductif selon l'une quelconque des revendications 1 à 15.

**17.** Amplificateur avec charge à commande inductive, qui présente un composant inductif selon l'une quelconque des revendications 1 à 15.

Fig. 1

Fig. 2

Fig. 3

Fig. 4

Fig. 5

**600**

f in GHz

602

601

511 in V

Fig. 6

**700**

f in GHz

702

701

506 in V

Fig. 7

Fig. 8

Fig. 9